# EUROPÄISCHE PATENTANMELDUNG

(11) **EP 2 790 196 A1**
(43) Veröffentlichungstag der Anmeldung: **15.10.2014**
(21) Anmeldenummer: 13162992.5
(22) Anmeldetag: 09.04.2013
(51) Int. Cl.: H01G 9/20, H01L 51/44, H01L 51/00

(54) **Elektrisch leitfähiges Substrat für eine optoelektrische Vorrichtung**

(71) Anmelder: Sefar AG, 9425 Thal (CH)
(72) Erfinder: Chabrecek, Peter, 9306 Freidorf (CH); Lantus, Muriel, 9442 Berneck (CH); Aubert, Marcel, 9425 Thal (CH); Hegelbach, Reto, 9425 Thal (CH)
(74) Vertreter: Behrmann, Niels

(57) **Zusammenfassung**

Die Erfindung betrifft ein elektrisch leitfähiges Substrat für eine optoelektronische Vorrichtung mit einem metallische oder metallisierte Fasern (14) sowie elektrisch nicht leitende, transparente polymere (16) oder Glasfasern aufweisenden Gewebe (12), welches mit einer ein transparentes, elektrisch nicht-leitendes Polymermaterial aufweisenden, teil- oder ganzflächigen Beschichtung (22,22') versehen ist, wobei das Substrat eine erste, elektrisch leitende Oberflächenseite sowie eine zweite, elektrisch nicht-leitende Oberflächenseite ausbildet, und das Gewebe so eingerichtet ist, dass ein elektrischer Flächenwiderstand des Substrats ≤ 10 Ω/sq beträgt, wobei entlang einer ersten Geweberichtung des Gewebes nur die metallischen oder metallisierten Fasern und entlang der orthogonal zur ersten Geweberichtung verlaufenden zweiten Geweberichtung des Gewebes nur die elektrisch nicht-leitenden Fasern vorgesehen sind, und/oder das Substrat auf seiner elektrisch nicht-leitenden Oberflächenseite eine insbesondere vollflächige, transparente und flexible Glas- oder Polymerfolie (10) so aufweist, dass diese das Polymermaterial berührend abdeckt und bevorzugt die Fasern des Gewebes berührt.

## Beschreibung

Die vorliegende Erfindung betrifft ein elektrisch leitfähiges Substrat für eine optoelektronische Vorrichtung nach dem Oberbegriff des Hauptanspruchs. Eine derartige Vorrichtung ist aus der deutschen Veröffentlichung 10 2008 055 969 der Anmelderin bekannt und beschreibt eine mittels eines Gewebes realisierte Leitelektrode, mit welcher verschiedene, flächige optoelektronische Vorrichtungen, etwa Solarzellen, elektrolumineszente Flächen, berührungsempfindliche Displays oder dergleichen realisiert werden können.

Vorteile der gattungsgemäßen Technologie sind insbesondere eine mechanische Flexibilität, da das Gewebe im Hinblick auf Biegeeigenschaften weitaus weniger Beschränkungen unterliegt, wie etwa eine traditionelle Realisierung (transparenter) elektrisch leitfähiger Flächenschichten mit Hilfe von bekannten, transparenten leitenden Oxiden, sogenannte TCO = Transparent Conductive Oxyde (etwa ITO). Die gattungsbildende, gewebebasierte Technologie ermöglicht zudem befriedigende elektrische Leitfähigkeitseigenschaften, ebenso wie (etwa für die Wirkungsgrade von mit einem solchen Substrat zu realisierenden optoelektronischen Vorrichtungen wichtige) Transmissionseigenschaften für einfallendes bzw. zu emittierendes Licht.

Gleichwohl ist eine solche, bekannte und als gattungsbildend vorausgesetzte Technologie gerade im Hinblick auf Ihre Prozessfähigkeit in der Herstellung und Fertigung, insbesondere auch für die Massenfertigung, noch optimierungsbedürftig; so ist es etwa notwendig, das gattungsgemäß für die im Gewebe vorzusehende Beschichtung verwendete Polymermaterial auf - bzw. einzubringen und aushärten zu lassen, bevor etwa das Substrat mit weiteren Schichten (etwa einer dielektrischen oder aktiven Schicht für eine damit zu realisierende optoelektronische Vorrichtung) versehen werden kann, anderenfalls würde etwa (relativ dünnflüssiges) dielektrisches Material bei einem solchen nachfolgenden Beschichtungsschritt unkontrolliert durch das Gewebe hindurch austreten. Ein vergleichbarer Effekt tritt dann auf, wenn es gewünscht sein sollte, die (polymere und transparente) Beschichtung aus dem elektrisch nicht-leitenden Polymermaterial am bzw. im Gewebe lediglich partiell bzw. teilflächig aufzubringen; auch hier würde dann, durch die nicht mit dieser Beschichtung versehenen Teilflächen des Gewebes, später aufzubringendes Material für die elektrooptischen Vorrichtungen schlecht kontrollierbar durch das Gewebe hindurch treten.

Ein weiteres Verbesserungspotenzial des gattungsgemäßen Substrats liegt in noch nicht optimierten elektrischen Leitfähigkeitseigenschaften, insbesondere im Wechselspiel zu den (nach wie vor notwendigen) hohen Transmissionseigenschaften des Substrates für Licht: Die gattungsgemäße DE 10 2008 055 969 offenbart verschiedene Möglichkeiten, das Gewebe in einer gewünschten Weise elektrisch leitend auszugestalten und so auch das damit realisierte Substrat (auf einer Oberflächenseite) leitend zu realisieren; neben der Verwendung von metallischen bzw. metallisierten Fasern (welche dann zu dem Gewebe verwoben werden) offenbart der gattungsbildende Stand der Technik insbesondere auch die Möglichkeit, ein Gewebe bzw. einen Gewebeabschnitt, etwa durch Bedampfen oder dgl., zu metallisieren. Während durch diese Maßnahmen die elektrischen Leitfähigkeitseigenschaften günstig eingerichtet werden können, gestattet dies gleichwohl keine optimale Transmission, da etwa bei einer Metallisierung eines (typischerweise dann aus Polymerfasern realisierten) Gewebes eine die Transmission erhöhender Effekt verloren geht, dass das (transparente) Fasermaterial selbst lichtdurchlässig bzw. lichtstreuend wirkt und so sich potenziell transmissionserhöhend auswirkt.

Aufgabe der vorliegenden Erfindung ist es daher, ein gattungsbildendes, elektrisch leitfähiges Substrat für eine optoelektronische Vorrichtung nach dem Oberbegriff des Hauptanspruchs sowohl im Hinblick auf ihre mechanischen und Verarbeitungseigenschaften zu verbessern, als auch die Transmissionseigenschaften bei möglichst hoher elektrischer Leitfähigkeit zu verbessern.

Die Aufgabe wird durch das elektrisch leitfähige Substrat mit den Merkmalen des Hauptanspruchs sowie des unabhängigen Patentanspruchs 3 gelöst; unabhängiger Schutz im Rahmen der Erfindung wird beansprucht für eine optoelektronische Vorrichtung unter Verwendung eines derartigen, elektrisch leitfähigen Substrates nach dem unabhängigen Patentanspruch 10.

Vorteilhafte Weiterbildungen der Erfindung sind in den Unteransprüchen beschrieben.

In erfindungsgemäß vorteilhafter Weise sieht die Erfindung zunächst vor, dass das Substrat auf seiner elektrisch nicht leitenden Oberfläche (bzw. zur Realisierung der elektrisch nicht-leitenden Oberflächenseite) mit einer vollflächigen, damit dichten und planen Folie aus einem Polymer oder Glasmaterial versehen ist, dergestalt, dass diese Folie in Kontakt mit dem transparenten, polymeren Beschichtungsmaterial der Beschichtung (im Gewebe) steht. Dies führt zunächst vorteilhaft dazu, dass - wichtig für eine Massen- bzw. Großserienfertigung, etwa im Wege der R2R- (Rolle-zu-Rolle) Fertigung - stets durch die Folie eine ganz- bzw. vollflächige, elektrisch nicht leitende Oberflächenseite ausgestaltet ist, welche dann zusätzlich als Barriere gegen ein- bzw. austretende Materialien dient: Wird etwa, gemäß einer günstigen Variante der Erfindung, die transparente, elektrisch nicht leitende Beschichtung im Gewebe lediglich partiell (teilflächig) aufgetragen, führt ein späteres Versehen des erfindungsgemäßen Substrats mit einer weiteren Schicht (etwa einer aktiven Schicht einer Solarzelle, einer dielektrischen Schicht oder dergleichen) nicht dazu, dass ein derartiges (oftmals auch flüssig aufgetragenes) Material unkontrolliert aus den nicht mit der Beschichtung versehenen Teilflächen austreten kann, vielmehr wirkt hier die erfindungsgemäße Glas- bzw. Polymerfolie als wirksame Sperrschicht. Gleichzeitig ist diese Schutz- und Sperrschicht gegen etwaige äußerliche Einflüsse.

Während es einerseits günstig und von der Erfindung umfasst ist, eine derartige Folie, welche typischerweise eine Foliendicke aufweist, die in der Größenordnung eines Faserdurchmessers der leitenden, d.h. metallischen bzw. metallisierten Fasern und/oder der elektrisch nicht-leitenden Fasern ist und bevorzugt zwischen 40 % und 60 % der Gewebedicke beträgt, durch Klebe- bzw. Haftprozesse, auch unter Nutzung des transparenten nicht-leitenden Polymermaterials der Beschichtung, an dem Gewebe zu befestigen, sieht gleichwohl eine bevorzugte Weiterbildung der Erfindung vor, durch Schweißvorgänge oder andere unlösbare Verbindungstechnologien (geeignet etwa mittels Ultraschall bzw. Laserschweißen) eine solche Folie am Gewebe bzw. an punktuellen Stellen des Gewebes festzulegen; entsprechend diesem Lösungsgedanken sieht der unabhängige Patentanspruch 3 dann vor, dass die hauptanspruchsgemäße Beschichtung mit dem Polymermaterial nicht notwendig ist.

Gleichermaßen von der Erfindung umfasst, ergänzend oder alternativ zur vorbeschriebenen Glas- bzw. Polymerfolie und insoweit auch als Weiterbildung des unabhängigen Patentanspruchs 3 ist vorgesehen, das erfindungsgemäße Gewebe so auszugestalten, dass entlang einer ersten Geweberichtung nur die metallischen bzw. metallisierten Fasern und entlang der orthogonal zu dieser ersten Geweberichtung verlaufenden zweiten Geweberichtung nur die elektrisch nicht leitenden Fasern (also die polymeren oder Glasfasern) vorgesehen sind. Gezielt wird mit dieser erfinderischen Maßnahme eine Unsymmetrie der elektrischen Leitungseigenschaften herbeigeführt, mit dem Vorteil, dass entlang der Richtung der leitenden (also der metallischen bzw. metallisierten) Fasern besonders günstige elektrische Leitfähigkeitseigenschaften erzeugt werden, was sich etwa bei entsprechender endseitiger Kontaktierung dieser Fasern an einem späteren flächigen Produkt, besonders gut auf einen geringen (und damit gewünschten) Spannungsabfall auswirkt; dies ermöglicht wiederum das Herstellen von Substrat und damit gebildeter elektrooptischer Vorrichtungen großer Nutzbreiten. Dagegen ermöglicht die dazu orthogonale Gewebeausbildung lediglich mittels der nicht-leitenden, transparenten Fasern eine Optimierung der Transmissionseigenschaften, so dass, gegenüber dem Stand der Technik, ein deutlicher Leistungsvorsprung im Hinblick auf die elektrooptischen Eigenschaften bei gleichzeitig verbesserter Fertigbarkeit realisiert ist: Typischerweise gestattet die vorliegende Erfindung entlang der Metallfaserrichtung eine elektrische Leitfähigkeit < 10 Ohm/sq bei Transmissionseigenschaften der Gesamtvorrichtung für Licht von > 80 %, wobei typischerweise eine offene Fläche (d.h. ein in der Projektion nicht von Fasern abgedeckter Anteil des Gewebes) zwischen ca. 65 % und ca. 85% beträgt.

Die Unteransprüche zur Ausgestaltung der transparenten Beschichtung, der Wahl der Faserdurchmesser bzw. der Faserabstände gestattet die Optimierung der Erfindung in Abhängigkeit von jeweiligen Einsatzerfordernissen und gewünschten Anwendungsfällen, wobei es sich in der Ausbildung des erfindungsgemäßen Gewebes und im Rahmen des vorliegenden Kontext als zusätzlich besonders vorteilhaft herausgestellt hat, wenn das Gewebe mit einer Gewebebindungsstruktur versehen wird, bei welcher die (in einer der Geweberichtungen verlaufenden) metallischen bzw. metallisierten Fasern in einer Bindung 2:1 bzw. größer, idealerweise im Bereich zwischen 2:1 und 5:1 verlaufen, also diese metallischen bzw. metallisierten Fasern mindestens zwei, bevorzugt zwei bis fünf der dazu orthogonalen, elektrisch nicht leitenden transparenten Fasern im Gewebe übergreifen. Vorteilhaft führt dies dann dazu, dass das freiliegende (und dann für eine elektrisch leitende Verbindung mit aufzubringenden weiteren Schichten für die elektrooptische Vorrichtung) Abschnitte der metallischen bzw. metallisierten Fasern auf der ersten (elektrisch leitenden) Oberflächenseite eine entsprechend erhöhte Kontaktfläche anbieten, so dass hier, neben der verbesserten elektrischen Leitfähigkeit, zusätzlich eine verbesserte elektrische Kontaktmöglichkeit in die weitere aufgebaute optoelektronische Vorrichtung erfolgt.

Hervorzuheben ist zudem bei allen Ausführungsformen, dass die vorliegende Erfindung eine Ausbildung des elektrisch leitfähigen Substrats, insbesondere auch der damit realisierten optoelektronischen Vorrichtung, ohne transparentes elektrisch leitendes Oxidmaterial, insbesondere ohne eine (als aus dem Stand der Technik allgemein bekannt vorauszusetzende, allerdings mit den obigen Nachteilen versehene) ITO-Schicht ermöglicht; offensichtlicher Vorteil ist, dass die durch die vorliegende Erfindung ermöglichten Ausgestaltungen sich ohne die bekannten Nachteile des spröden Oxidmaterials, etwa begrenzte Biegeradien, die Gefahr von Splittern oder dergleichen sowie stark abnehmende Helligkeitsverläufe entlang einer Fläche durch große Flächenwiderstände, sich in mehrfacher Richtung durch optimierte Betriebs- und Verarbeitungseigenschaften auszeichnen.

Auch gegenüber anderen, als aus dem Stand der Technik bekannt vorauszusetzenden Technologien ist die vorliegende Erfindung vorteilhaft; insbesondere bei der Verwendung vorteilhaft dünner Metallfäden im Bereich < 20 µm lässt sich etwa eine Struktur ausbilden, welche derzeit nicht auf andere Weise realisierbar ist; so gestatten etwa auch Druckverfahren keine 20 µm dünnen Linien.

Im Ergebnis ist damit ein elektrisch leitfähiges Substrat geschaffen, welches schon die bisherige, als gattungsbildend bekannt vorausgesetzte Technologie mehrdimensional optimiert und damit zusätzlich noch weiteren Anwendungszwecken im Bereich der optoelektronischen Vorrichtungen (und auch darüber hinaus) zugänglich macht.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Fig. 1: ein elektrisch leitfähiges Substrat für eine optoelektronische Vorrichtung gemäß einer ersten bevorzugten Ausführungsform in schematischer Schnittansicht,
- Fig. 2: eine Schnittansicht analog Fig. 1 zum Verdeutlichen des elektrisch leitfähigen Substrats gemäß einer zweiten Ausführungsform und
- Fig. 3: eine Draufsicht auf die elektrisch leitende Oberflächenseite des elektrisch leitfähigen Substrats in besonderer Ausgestaltung der Gewebestruktur.

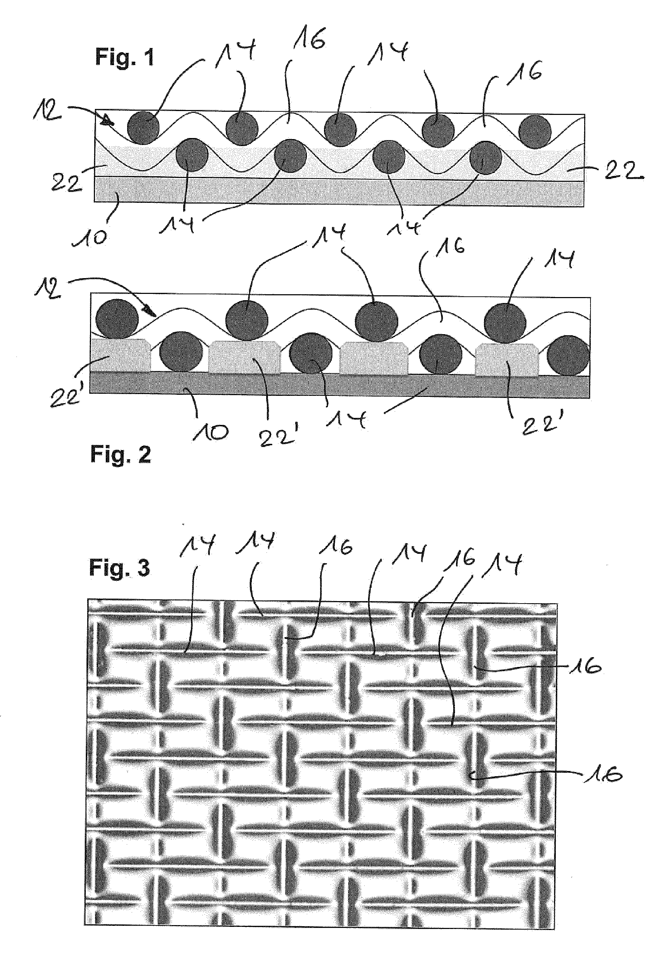

Die Figur 1 zeigt in der schematischen Schnittansicht ein erstes Ausführungsbeispiel des erfindungsgemäßen Substrats, mit einer nach oben freiliegenden ersten und einen elektrischen Oberflächenwiderstand < 10 Ohm/sq ausbildenden Oberflächenseite sowie einer nach unten (d.h. in der Figurenebene abwärts) gerichteten zweiten, elektrisch nicht leitenden Oberflächenseite, hier realisiert durch einen Polymer- oder Glasfilm 10 mit einer exemplarischen Dicke von 25 µm. Verbunden mit diesem Film 10 ist ein Gewebe 12, bestehend aus entlang der Schussrichtung angeordneten Metallfasern (Metallfäden) 14 einer Dicke von 25 µm; ein Abstand einander benachbarter der Metallfäden (diese verlaufen lediglich entlang der Schussrichtung und weisen keine dazwischenliegenden Polymerfäden auf) liegt bei ca. 150 µm. Entlang der Kettrichtung des Gewebes 12 verlaufen transparente Polymerfasern 16 einer Dicke von 25 µm, realisiert aus einem semitransparenten Monofilament von PEN. Ein Abstand zwischen benachbarten der Polymerfasern 16 entlang der Kettrichtung beträgt etwa 200 µm, so dass das Gewebe Öffnungsflächen von ca. 30.000 µm² ausbildet und, eingeschlossen diffuse Transmissionseffekte, eine Transmission von > 70 % realisiert.

Wie die Schnittansicht der Fig. 1 erkennen lässt, ist zusätzlich und mit einer Schichtdicke von 20 µm eine Beschichtung 22 aus einem Polymermaterial so in das Gewebe 14 eingebracht, dass die Beschichtung 22 in Kontakt mit der unterliegenden Folie 10 steht und damit in etwa die obere Hälfte des Gewebes aus diesem transparenten Polymermaterial heraussteht. Damit geben dann insbesondere die (aus dieser PolymerSchicht 22) freiliegenden Abschnitte der leitenden Fasern 14 die Möglichkeit, auf die nach oben zeigende leitende Oberflächenseite weitere Schichten einer aufzubauenden optoelektronischen Vorrichtung kontaktbildend aufzubringen, etwa eine zum Ausbilden einer Solarzelle geeignete dielektrischen oder aktiven Schicht. Beim Ausführungsbeispiel der Fig. 1 sorgt die hier ganzflächig aufgetragene Beschichtung 22 dafür, dass das in der Art einer Sperrschicht, dieses zusätzliche (ggf. auch flüssig aufzutragende) Schichtmaterial nicht aus der Gewebestruktur nach unten austreten kann.

Die Figur 2 verdeutlicht ein zweites, alternatives Ausführungsbeispiel der Erfindung, wobei gleiche bzw. äquivalente Komponenten mit der Fig. 1 identischen Bezugszeichen versehen sind. Wiederum ist ein Gewebe 12 der im Zusammenhang mit Fig. 1 beschriebenen Art auf einer unterliegenden Polymerfolie 10 durch punktuelles Verschweißen befestigt. Im Gegensatz zu einer ganzflächigen Beschichtung 22 der Fig. 1 enthält jedoch dieses zweite Ausführungsbeispiel lediglich teilflächige Abschnitte 22' aus dem vernetzten oder nicht vernetzten Polymermaterial, so dass, wie in der Fig. 2 in der Schnittansicht angedeutet, Abstände zwischen diesen Abschnitten 22' entstehen. Vorteilhaft wirkt hier die Folie 10 zusätzlich als Sperrschicht etwa gegenüber solchem (flüssig) aufzutragenden Material, welches ansonsten durch die gebildeten Lücken hindurch aus dem Gewebe in unerwünschter Art und Weise heraustreten würde. Im Ausführungsbeispiel der Fig. 2 weisen die Beschichtungsabschnitte 22' eine erhöhte Schichtdicke von 25 µm auf.

Die Draufsicht auf die elektrisch leitende Oberflächenseite einer weiteren Ausführungsform des erfindungsgemäßen Substrats zeigt die Fig. 3; wiederum sind leitende Fasern als Metallfasern, in Schussrichtung verlaufend, mit den Bezugszeichen 14, dagegen nicht-leitende, transparente Polymerfasern, in Kettrichtung verlaufend mit den Bezugszeichen 16 versehen. Die Draufsicht der Fig. 3 verdeutlicht eine vorteilhafte 2:1 Bindung, d.h. die Metallfäden übergreifen jeweils zwei orthogonal dazu verlaufende Polymerfäden, wobei aus dieser Ansicht auch deutlich wird, dass mit dieser bevorzugten (als weiter bevorzugte Variante auch bis zu 5:1 gestaltbaren) Struktur, die elektrische Kontaktierbarkeit der Metallfäden weiter optimiert ist.

In den Figuren nicht gezeigt ist eine Variante der Erfindung, bei welcher eine Substratanordnung analog einer der Figuren 1 bis 3 keine Beschichtung 20 bzw. 22' aufweist, vielmehr die in Kontakt mit der Folie 10 stehenden Fäden 14 bzw. 16 geeignet punktuell (zB. in regelmäßigen Rasterungen bzw. Abständen) mit der Folie durch ein Ultraschall- oder Laser-Verbindungsverfahren, insbesondere Schweißen, unlösbar verbunden sind.

Die vorliegende Erfindung ist nicht auf die beschriebenen Ausführungsbeispiele beschränkt, vielmehr sind zahlreiche Varianten (auch diese, wie nachfolgend erläutert, nicht-ausschließlich) möglich:

So ist es zunächst bevorzugt, die Polymerschicht (22 bzw. 22') in der Größenordnung einer Hälfte der Gewebedicke aufzubringen, bevorzugt ist es aber auch diese Schichtdicke < 50 % der Gewebedicke, weiter bevorzugt zwischen 20 und 50 % der Gewebedicke, aufzubringen. Diese Beschichtung ist vorteilhaft mit (nicht-vernetzten oder vernetzten) Polymeren/Lacken auf der Basis von Epoxydharzen, PU-Acrylharzen, Silikonharzen, Fluorpolymeren oder anderen geeigneten Polymeren möglich, wobei eine Vernetzung entweder thermisch oder mit Hilfe von UV-Strahlung erfolgen kann.

Die verwendeten, elektrisch leitenden, metallischen oder metallisierten Fasern können als Metalle etwa Ti, Ag, Al, Cu, Au, PA, PT, Ni, W, Mo, Nb, Ba, Sn, Zr oder dergleichen aufweisen, wobei diese Metalle entweder in massiver Form eine Faser ausbilden, alternativ mit diesen Metallen ein (z.B. polymerer) Kern vor dem Verweben umhüllt bzw. beschichtet ist.

Dagegen sind die elektrisch nicht leitenden Fasern besonders bevorzugt semitransparente Monofilamente von PEN, PA, PP, PET, PEEK, PI, PPS oder dergleichen Chemiefasern, alternativ Glasfasern bzw. Glasfäden, wobei die Durchmesser jeweils bevorzugt im Bereich zwischen 20 und 50 µm liegen (bei typischen Durchmessern der leitenden Metallfäden im Bereich zwischen 15 und 70 µm).

Damit entsteht dann ein Gewebe, welches im Hinblick auf die Abstände zwischen den nicht-leitenden transparenten Fasern, eine Abstandsgeometrie zwischen 200 und 300 µm (jeweils zwischen einander benachbarten Fasern) aufweist, dagegen sind Abstände zwischen den leitenden Metallfasern auf ein Bereich zwischen 100 und 500 µm eingerichtet, wobei es jedoch im Rahmen der Erfindung bevorzugt ist, die Abstände zwischen den Metallfasern kleiner einzurichten als die Abstände zwischen den Polymerfasern.

Durch eine solche Ausgestaltung entstehen typische Öffnungsflächen zwischen den Gewebefasern im Bereich zwischen 20.000 und 150.000 µm², mit einer offenen Fläche, welche ca. zwischen 65 % und 85 % der Gewebefläche ausmacht und eine Transmission (allerdings unter Berücksichtigung der oben beschriebenen diffusen Transmission unter Einbezug der transparenten Fasern) von > 80 % gestattet.

Die vorliegende Erfindung ermöglicht damit in potenziell einfacher, eleganter und preiswerter Weise die Herstellung von optoelektronischen Vorrichtungen für eine Vielzahl von Anwendungen: während sich die Photovoltaik als Hauptanwendung für die vorliegende Erfindung erweisen dürfte, wobei insbesondere organische Solarzellen, Dünnschichtzellen oder DSC-Zellen in der erfindungsgemäßen Weise auf das Substrat aufgebracht werden können, ist es gleichwohl günstig und von der Erfindung umfasst, andere optoelektronische Vorrichtungen mit dem Substrat zu realisieren; hierzu gehören organische LEDs, sonstige Display-Technologien, EL-Flächen, verschiedene passive elektronische Bauelemente oder aber großflächige Bauelemente, wie sie etwa für Architekturanwendungen verwendet werden können.

Damit werden nicht nur die oben diskutierten Vorteile gegenüber den bekannten TCO-Elektroden realisiert, wie etwa deutlich verbesserte elektrische und mechanische Eigenschaften, ferner deutlich niedrigere Herstellungs- und Materialkosten, das fehlende Erfordernis einer speziellen Vakuumdruckanlage (für das Aufbringen von TCO im Hochvakuum), überhaupt scheint erstmals durch die vorliegende Erfindung die Voraussetzung dafür geschaffen zu sein, auch großflächige Substratflächen in Rolle-zu-Rolle-Verfahren und damit kontinuierlich effizient fertigen zu können.

## Patentansprüche

1. Elektrisch leitfähiges Substrat für eine optoelektronische Vorrichtung mit
einem metallische oder metallisierte Fasern (14) sowie elektrisch nicht- leitende, transparente polymere (16) oder Glasfasern aufweisenden Gewebe (12),
welches mit einer ein transparentes, elektrisch nicht-leitendes Polymermaterial aufweisenden, teil- oder ganzflächigen Beschichtung (22,22') versehen ist, wobei das Substrat eine erste, elektrisch leitende Oberflächenseite sowie eine zweite, elektrisch nicht-leitende Oberflächenseite ausbildet,
und das Gewebe so eingerichtet ist, dass ein elektrischer Flächenwiderstand des Substrats ≤ 10 Ω/sq beträgt,
**dadurch gekennzeichnet, dass**
entlang einer ersten Geweberichtung des Gewebes nur die metallischen oder metallisierten Fasern und entlang der orthogonal zur ersten Geweberichtung verlaufenden zweiten Geweberichtung des Gewebes nur die elektrisch nicht-leitenden Fasern vorgesehen sind, und/oder
das Substrat auf seiner elektrisch nicht-leitenden Oberflächenseite eine insbesondere vollflächige, transparente und flexible Glas-oder Polymerfolie (10) so aufweist, dass diese das Polymermaterial berührend abdeckt und bevorzugt die Fasern des Gewebes berührt.

2. Substrat nach Anspruche 1, **dadurch gekennzeichnet, dass** die Beschichtung in einem vernetzten und/oder ausgehärteten Zustand eine Beschichtungsdicke ausbildet, die weniger als 50 % der Gewebedicke beträgt.

3. Elektrisch leitfähiges Substrat für eine optoelektronische Vorrichtung mit
einem metallische oder metallisierte Fasern (14) sowie elektrisch nicht- leitende, transparente polymere (16) oder Glasfasern aufweisenden Gewebe (12),
wobei das Substrat eine erste, elektrisch leitende Oberflächenseite sowie eine zweite, elektrisch nicht-leitende Oberflächenseite ausbildet,
und das Gewebe so eingerichtet ist, dass ein elektrischer Flächenwiderstand des Substrats ≤ 10 Ω/sq beträgt,
**dadurch gekennzeichnet, dass**
das Substrat auf seiner elektrisch nicht-leitenden Oberflächenseite eine insbesondere vollflächige, transparente und flexible Glas-oder Polymerfolie (10) so aufweist, dass diese mit Fasern des Gewebes punktuell unlösbar verbunden ist, insbesondere die Glas- bzw. Polymerfolie an dem Gewebe durch Ultraschall-oder Laserschweißen unlösbar befestigt ist.

4. Substrat nach einem der Ansprüche 1 bis 3, **dadurch gekennzeichnet, dass** ein erster Faserabstand einander benachbarter der metallischen oder metallisierten Fasern ≤ 500 µm, bevorzugt ≤ 180 µm, weiter bevorzugt ≤ 160 µm sowie ≥ 100 µm beträgt

5. Substrat nach einem der Ansprüche 1 bis 4, **dadurch gekennzeichnet, dass** das Gewebe eine Gewebebindungsstruktur so aufweist, dass aus der Richtung der ersten Oberflächenseite die metallischen bzw. metallisierten Fasern mindestens zwei, bevorzugt zwei bis fünf, der elektrisch nicht-leitenden transparenten Fasern übergreifen.

6. Substrat nach einem der Ansprüche 1 bis 5, **dadurch gekennzeichnet, dass** ein Faserdurchmesser der metallischen bzw. metallisierten Fasern zwischen 15 µm und 70 µm beträgt und bevorzugt ≤ 25 µm, weiter bevorzugt ≤ 20 µm beträgt.

7. Substrat nach einem der Ansprüche 1 bis 6, **dadurch gekennzeichnet, dass** ein Faserdurchmesser der elektrisch nicht-leitenden, transparenten Fasern zwischen 20 µm und 50 µm beträgt.

8. Substrat nach einem der Ansprüche 1 bis 7, **dadurch gekennzeichnet, dass** das Gewebe so ausgebildet ist, dass der erste Faserabstand kleiner als der zweite Faserabstand ist, insbesondere weniger als 90 %, weiter bevorzugt weniger als 80 % des zweiten Faserabstands beträgt.

9. Substrat nach einem der Ansprüche 1 bis 8, **dadurch gekennzeichnet, dass** das Substrat kein transparentes, elektrisch leitendes Oxidmaterial (TCO) aufweist.

10. Optoelektronische Vorrichtung mit dem elektrisch leitfähigen Substrat nach einem der Ansprüche 1 bis 9 und einer zum elektrischen Zusammenwirken mit der ersten Oberflächenseite ausgebildeten aktiven, halbleitenden, phosphoreszierenden und/oder dielektrischen Schicht, wobei die optoelektronische Vorrichtung keine ein transparentes Leitoxid (TCO) aufweisende Schicht aufweist.
